# EUROPEAN PATENT SPECIFICATION

(11) **EP 4 446 368 B1**
(45) Date of publication and mention of the grant of the patent: **25.02.2026**
(21) Application number: 22905911.8
(22) Date of filing: 02.08.2022
(51) Int. Cl.: C08J 7/043, C08J 7/04, G03F 7/00, C08L 67/02, C08L 79/08, C08L 23/12, C08L 27/06, C09D 187/00, C08G 81/02, B60R 13/00, C09J 7/40

(54) **IMPRINTING PHOTORESIST RELEASE FILM MATERIAL WITH EXHAUSTING FUNCTION, AND PREPARATION METHOD THEREOF AND USE THEREOF**
PRÄGEPHOTORESIST-TRENNFILMMATERIAL MIT AUSGASUNGSFUNKTION, VERFAHREN ZU SEINER HERSTELLUNG UND SEINE VERWENDUNG
MATÉRIAU DE FILM DE TYPE À LIBÉRATION DE RÉSINE PHOTOSENSIBLE GAUFRÉE AYANT UNE FONCTION D'ÉCHAPPEMENT, SON PROCÉDÉ DE PRÉPARATION, ET SON APPLICATION

(30) Priority: 14.12.2021 CN 202111524295
(43) Date of publication of application: 16.10.2024
(73) Proprietor: Jinwanzheng (Guangdong) New Material Co., Ltd, Zhaoqing, Guangdong 526238 (CN)
(72) Inventor: LI, Shufeng, Guangzhou, Guangdong 526238 (CN); LI, Shumang, Guangzhou, Guangdong 526238 (CN); LI, Shuyu, Guangzhou, Guangdong 526238 (CN)
(74) Representative: Bayramoglu et al.
(86) International application number: PCT/CN2022/109752
(87) International publication number: WO 2023/109149

(56) References cited:
- WO-A1-2014/197375
- CN-A- 101 511 592
- CN-A- 102 199 402
- CN-A- 102 666 094
- CN-A- 109 016 788
- CN-A- 114 196 349
- CN-U- 210 855 940
- CN-U- 216 445 286
- JP-A- 2019 098 748
- JP-A- 2019 098 748
- KR-A- 20190 101 646
- KR-A- 20200 058 096
- BIN ZHANG, ZHANG XU-GANG, ZHANG MI-LIN, SUN MING-MING, LI JIAN-HUI: "Epoxy Resin Modified by Liquid Acrylate Oligomer Containing Epoxy Groups", JOURNAL OF MATERIALS ENGINEERING, 20 April 2007 (2007-04-20), pages 3 - 6, XP093072400
- PENG GAO, XUE XIANG-XIN: "Some Influencing Factors on Preparation Process of Epoxy Acrylate Oligomer", JOURNAL OF NORTHEASTERN UNIVERSITY(NATURAL SCIENCE), vol. 30, no. 6, 15 June 2009 (2009-06-15), pages 29 - 32, XP093072403

## Description

### TECHNICAL FIELD

The present invention relates to the technical field of high molecular materials, and in particular to an imprinting photoresist release film material with an exhausting function, and a preparation method thereof and use thereof.

### BACKGROUND

Release paper or a release film is to coat the surface of paper or a polymer film with an Organosilicon release agent on one side or two sides to form organosilicon release paper or an organosilicon release film, also referred to as silicone paper or a silicone film. The release paper or film is generally used to isolate a viscous material, and widely used in the fields of packaging, printing, flexible circuit boards, insulating materials, bonding, electronics, adhesive products, die cutting and stamping processing, and the like. The release paper or film can show a stable release force for various organic pressure-sensitive adhesives (such as hot melt adhesive, acrylic adhesive and rubber-based pressure-sensitive adhesive). The adhesive surface of the traditional pressure-sensitive adhesive tape/label is smooth and flat. When the pressure-sensitive adhesive tape/label is bonded on a target, if the temperature of the target changes or the area of an adhesive film is large, the pressure-sensitive adhesive tape or label is prone to produce bubbles or bulges on the surface of an adherend in the bonding process, so that the use performance and the beauty of the adherend; and if the adherend is an object that often emits heat, such as mobile phone, storage battery, display, laptop, car cover and wrap film, the bubbling phenomenon of the pressure-sensitive adhesive tape or label is more serious.

With the development of industry technology, the technology and application field of the release paper or film is constantly extended and improved. The release paper or film has the pressure-sensitive adhesive release use. As an innovation, an embossed release film (such as CN201610615758.5) has appeared in the industry. A polyethylene (PE) film is sprayed on the surface of a release substrate layer, and textures are formed on the film-spraying film by a textured roll wheel. However, due to the low hardness and melting point of the PE film, on one hand, the process is difficult in the imprinting process, and on the other hand, even after forming, the stability of the textures are difficult to maintain in the subsequent thermocuring process.

### SUMMARY

To overcome the shortcomings in the prior art, an objective of the present invention is to provide an imprinting photoresist release film material with an exhausting function. An imprinting photoresist layer is formed on the base material layer, and effective exhausting ditches or exhausting grooves are imprinted and formed through mechanical contact, so that the exhausting problem of viscous materials or pressure-sensitive adhesive products.

To solve the above problem, the present invention adopts the following technical solutions:
an imprinting photoresist release film material with an exhausting function includes:
a substrate layer, having an upper surface and a lower surface; and further comprising:
a photoresist prepolymer obtained by introducing the bisphenol A epoxy resin into a liquid acrylate oligomer and performing copolymerization. The liquid acrylate oligomer is prepared by reacting the following components in parts by weight: 70-80 parts of butyl acrylate, 20-30 parts of glycidyl methacrylate, 3-5 parts of dibenzoyl peroxide and 1-2 parts of hydroquinone. The upper surface or/and the lower surface of the substrate layer is/are coated with the photoresist prepolymer; while the photoresist prepolymer is cured through optical radiation to form an imprinting photoresist layer, the surface of the imprinting photoresist layer is imprinted through mechanical contact to form a plurality of exhausting ditches or exhausting grooves; and
the plurality of exhausting ditches or exhausting grooves divide the imprinting photoresist layer into a plurality of bumps.

As a further preferred solution, the surface of the imprinting photoresist layer is imprinted through mechanical roll imprinting or transfer film transferring to form the exhausting ditches or exhausting grooves of the present invention.

As a further preferred solution, a copolymerization system of the liquid acrylate oligomer and the bisphenol A epoxy resin of the present invention further includes 40-50% of reactive diluent, 0.1-0.75% of catalyst, 3-6% of adhesion accelerator and 1-5% of polymerization inhibitor based on the respective mass ratio of the reaction system.

As a further preferred solution, the pencil hardness of the imprinting photoresist layer of the present invention is greater than or equal to 2H tested by a film-coating pencil scratch hardness tester according to the GB/T6739-2006 pencil test method.

As a further preferred solution, the distance between every two adjacent exhausting ditches or exhausting grooves is 200-600 µm, the width of the exhausting ditches or exhausting grooves is 6-60 µm, and the depth of the exhausting ditches or exhausting grooves is 3-30 µm.

As a further preferred solution, the imprinting photoresist release film material with an exhausting function of the present invention further includes a release layer formed by coating the imprinting photoresist layer with a polysiloxane release agent, and the dry coating amount of the polysiloxane release agent is 0.5-2.5 g/m².

As a further preferred solution, the substrate layer of the present invention is one of a polyethylene glycol terephthalate film, a polyimide film, a polypropylene film and a polyvinyl chloride film, or one of modifiers, homopolymers, copolymers or derivatives of polyethylene glycol terephthalate, polyethylene glycol terephthalate, polypropylene and polyvinyl chloride.

The present invention further provides a preparation method for an imprinting photoresist release film material with an exhausting function. The preparation method includes:
preparing a liquid acrylate oligomer: mixing 70-80 parts of butyl acrylate, 20-30 parts of glycidyl methacrylate, 3-5 parts of dibenzoyl peroxide and 1-2 parts of hydroquinone, and heating and polymerizing the mixture in water bath to obtain the liquid acrylate oligomer;
preparing a photoresist prepolymer: introducing bisphenol A epoxy resin into the liquid acrylate oligomer and performing copolymerization to obtain the photoresist prepolymer;
performing coating with the photoresist prepolymer: coating the upper surface or lower surface of the substrate layer with the photoresist prepolymer; and
curing and imprinting the exhausting ditches or exhausting grooves: while performing optical radiation on the coated photoresist prepolymer to form the imprinting photoresist layer, forming the exhausting ditches or exhausting grooves on the surface of the imprinting photoresist layer by an engraving roll with a bumped structure.

As a further preferred solution, the preparation method of the present invention further includes:
performing coating with the release agent: coating the surface of the imprinting photoresist layer with the release layer formed by a siloxane release agent, the dry coating amount of the siloxane release agent being 0.5-2.5 g/m².

The present invention further provides use of an imprinting photoresist release film material with an exhausting function in isolating a viscous material and/or a pressure-sensitive adhesive material. In practical application, the viscous material and/or the pressure-sensitive adhesive material is bonded to the release film material, and the exhausting ditches or exhausting grooves are formed in the surface of the viscous material and/or the pressure-sensitive adhesive material through copying of the release film.

The present invention further provides use of an imprinting photoresist release film material with an exhausting function in a car cover and a wrap film.

The present invention provides a car cover, including a surface material, an adhesive layer anchored on a lower surface of the surface material, and a release film bonded to the adhesive layer. The release film is the imprinting photoresist release film material with an exhausting function of the present invention; and after the surface material and the adhesive layer anchored on the lower surface of the surface material are bonded to the imprinting photoresist release film material, the adhesive layer on the lower surface of the surface material is imprinted by the bumps on the surface of the imprinting photoresist layer, and the exhausting ditches or exhausting grooves matched therewith are formed in the adhesive layer.

The present invention provides a wrap film, including a surface material, an adhesive layer anchored on a lower surface of the surface material, and a release film bonded to the adhesive layer. The release film is the imprinting photoresist release film material with an exhausting function of the present invention; and after the surface material and the adhesive layer anchored on the lower surface of the surface material are bonded to the imprinting photoresist release film material, the adhesive layer on the lower surface of the surface material is imprinted by the bumps on the surface of the imprinting photoresist layer, and the exhausting ditches or exhausting grooves matched therewith are formed in the adhesive layer.

The below documents are considered as prior art documents.

D1: KR20190101646A; Pattered Adhesive tape Release film for forming the same and Method of producing Release film; 2 September 2019. D1 discloses a patterned adhesive tape, a release film forming the same, and a method for producing a release film having at least one selected from a UV-curable acrylate resin, a UV-curable epoxy resin, or an EB-curable vinyl resin.

D2: KR20200058096A; The monolithic structure of Patterned Release film Method of producing the same and Adhesive tape produced from the same; 27 May 2020. D2 discloses a release film having a single patterned coating structure having a UV curable release resin layer formed on the base film.

D3: JP2019098748A; RELEASE FILM; 24 June 2019. D3 discloses a release film having a concavo-convex structure on the surface, which is capable of transferring the concavo-convex structure to the surface of a film laminated on the release film.

Compared with the prior art, the present invention has the beneficial effects as follows:
1. In the imprinting photoresist release film material with the exhausting function of the present invention, while the photoresist prepolymer is cured to form the imprinting photoresist layer, the surface of the imprinting photoresist layer is imprinted through mechanical contact to form the exhausting ditches or exhausting grooves; when the bumps separated by the exhausting ditches or exhausting grooves are bonded to the adhesive layer on the lower surface of the surface material, the exhausting ditches or exhausting grooves matched therewith are formed in the adhesive layer, so that the exhausting problem of the pressure-sensitive adhesive material and the adherend can be effectively solved, bubbling can be avoided, and the bonding convenience between the pressure-sensitive adhesive material and the adherend can be improved.
2. In the imprinting photoresist release film material with the exhausting function of the present invention, the exhausting ditches or exhausting grooves are formed through imprinting of a mechanical press roll or a transfer film, the mechanical press roll and the transfer film are equivalent to a mold for imprinting the exhausting ditches or exhausting grooves, and the release material with the exhausting ditch or exhausting groove structure imprinted by the mechanical press roll is suitable for non-transparent products or products with low transparency requirement. The size of the exhausting ditches or exhausting grooves formed through transferring of the transfer film can reach a nanometer structure, and the release material with fine textures obtained by this method can be used in optical products with high requirement on the transparency of the surface material. Further, the transfer film can be reused.
3. The imprinting photoresist release film material with the exhausting function of the present invention has toughness, high hardness and excellent anchoring force.

The present invention will be further described in detail below with reference to specific implementations.

### BRIEF DESCRIPTION OF THE DRAWINGS

FIG. 1 is a diagram showing the influence of a catalyst on the conversion rate of a photoresist prepolymer;
FIG. 2 is a diagram showing the influence of a reaction temperature on the conversion rate of a photoresist prepolymer;
FIG. 3 is the influence result of the use amount of an acrylate oligomer on the mechanical property of a photoresist layer, where (a) tensile strength and modulus, (b) elongation, (c) bending strength and modulus, (d) deflection, and (e) impact strength; and
FIG. 4 is the influence result of the use amount of GMA on the mechanical property of a photoresist layer, where (a) tensile strength and modulus, (b) elongation, (c) bending strength and modulus, (d) deflection, and (e) impact strength.

### DETAILED DESCRIPTION OF THE EMBODIMENTS

Terms and nouns involved in the present invention are explained as follows:
"photoresist prepolymer" involved in the present invention means that a prepolymer has a photosensitive group, and can be cured or etched under optical radiation, imprinting photoresist is formed by the photoresist prepolymer, and the imprinting photoresist layer is different from the photoresist in the traditional electronic field and is a coating capable of realizing graphic reproduction through mechanical contact.
"Adhesion" involved in the present invention refers to an adhesion of a coating or paint on a base material, and the adhesion directly affects the use of the material. The coating with a poor adhesion will easily fall off the base material, particularly a flexible film material. The adhesion test of the coating of the present invention is referenced to the GB/T9286-1998 method. The adhesion of the coating film is determined by a cross-cut test.
"Pencil hardness" involved in the present invention refers to the pencil hardness after the paint or coating is cured into a film, and the hardness after the paint is cured into the film is a main parameter which determines whether the hardness and the scratch resistance of the surface of the film material can be improved. The hardness of the coating in the present invention is a standard test method for measuring the hardness of the coating film with reference to the GB/T6739-2006 pencil test method, and the pencil hardness of the coating is tested by a film-coating pencil scratch hardness tester.

For the description of the solution of the present invention, the present invention provides an imprinting photoresist release film material with an exhausting function, including:
a substrate layer, having an upper surface and a lower surface; and further comprising:
a photoresist prepolymer. The upper surface or/and the lower surface of the substrate layer is/are coated with the photoresist prepolymer; while the photoresist prepolymer is cured through optical radiation to form an imprinting photoresist layer, the surface of the imprinting photoresist layer is imprinted through mechanical contact to form a plurality of exhausting ditches or exhausting grooves; and
the plurality of exhausting ditches or exhausting grooves divide the imprinting photoresist layer into a plurality of bumps.

**[Substrate layer]**: the substrate layer of the present invention refers to a film layer in a release film for being separated from a viscous material or pressure-sensitive adhesive material, and is a carrier for forming exhausting ditches or exhausting grooves and/or a release layer. The present invention has no special requirements on the selection of the substrate layer, as long as an adhesive layer can be coated and radiated, a certain tensile strength can be achieved, and particularly the requirement of high-temperature resistance in the subsequent application can be met. From the cost point of view, the substrate layer may be a polymer film and a paper-based or curled base material with the tensile strength. The thickness of the substrate layer is also not particularly limited. From the cost point of view, the thickness of the polymer film may be 10-200 microns, preferably, 75-100 microns. In the present invention, the selection of the base material is based on the temperature resistance of the subsequent use. Preferably, the substrate layer is a polyethylene glycol terephthalate film, a polyimide film, a polypropylene film, a polyvinyl chloride film, and modification, homopolymerization, copolymerization, coextrusion, polymers and derivatives thereof. The substrate layer of the present invention may select a paper-based type and may be any gram weight. According to the present invention, the upper surface or lower surface of the substrate layer is coated with a modified epoxy resin prepolymer, and the exhausting ditches or exhausting grooves are formed through imprinting and radiation curing; and according to the application requirements, the upper surface and lower surface of the substrate layer are coated with the modified epoxy resin prepolymer, and the exhausting ditches or exhausting grooves are formed through imprinting and radiation curing. In some application requirements, any one of the upper surface or lower surface or the upper surface and lower surface may be subjected to imprinting and radiation curing to form the exhausting ditches or exhausting grooves; and in some application requirements, any one of the upper surface or lower surface or the upper surface and lower surface may be subjected to imprinting and radiation curing to form the exhausting ditches or exhausting grooves, and the exhausting ditches or exhausting grooves are coated with release agents to form the release film material of which the upper surface and/or lower surface have the exhausting ditches or exhausting grooves. Due to various excellent characteristics of no toxicity, no odor, high tensile strength, excellent stiffness, warping resistance, insusceptibility to breakage, high oxygen inhibition, high moisture inhibition, cold resistance, heat resistance, chemical corrosion resistance, stable size and the like, the PET film serves as a preferred base material.

**[Exhausting ditch or exhausting groove]**: the exhausting ditches or exhausting grooves of the present invention are arranged on a photoresist layer, and are a plurality of exhausting ditches or exhausting grooves pressed or imprinted on the imprinting photoresist layer through mechanical contact; these exhausting ditches or exhausting grooves divide the imprinting photoresist layer into a plurality of bumps; and the bumps imprint the adhesive layer on the lower surface of the surface material bonded to the imprinting photoresist layer to form the grooves matched therewith. The shape of the bumps may be one of a circular truncated cone, cylinder, a trapezoidal table, a cube and a cuboid. On the other hand, to form the bumps with various structures, the shape of the longitudinal section of the exhausting ditches or exhausting grooves may select but not limited to one of the sectional shapes such as a "V" shape, a "U" shape, a rectangular shape, a trapezoidal shape or a semi-circular shape. In the specific implementation solution of the present invention, the distance between every two adjacent exhausting ditches or exhausting grooves is 200-600 µm; and the distance generally refers to a distance between the bottoms of every two adjacent exhausting ditches or exhausting grooves, or may be regarded as the width of the bottom of the bumps. Further, the width of the exhausting ditches or exhausting grooves is 6-60 µm, and the depth of the exhausting ditches or exhausting grooves is 3-30 µm. The depth of the exhausting ditches or exhausting grooves of the present invention may be adjusted by the coating amount of the prepolymer. The coating amount of the prepolymer is small if the depth size is small, and the coating amount of the prepolymer is large if the depth size is large. The depth of the exhausting ditches or exhausting grooves may penetrate through the photoresist layer or not penetrate through the photoresist; and the width size of the exhausting ditches or exhausting grooves changes with the change of the depth size. In the present invention, the size of the exhausting ditches or exhausting grooves is set, so that when the release film material in the application process is bonded to the adhesive layer on the lower surface of the surface material, an effective concave-convex structure can be formed on the adhesive layer, the construction of the viscous material or pressure-sensitive adhesive material can be facilitated, and the influence on the beauty and performance of the bonded product caused by bubbles or bulges between the pressure-sensitive adhesive material and the adherend during use can be avoided.

**[Photoresist layer]**: the imprinting photoresist layer of the present invention is a coating formed by coating the surface of the base material with the photoresist prepolymer, and the imprinting photoresist layer can be peeled off with the base material of the release film in the application of the release film. In the present invention, the used photoresist prepolymer is a modified epoxy resin prepolymer; the imprinting photoresist is different from the traditional photoresist because the photoresist prepolymer includes a photosensitive group and can be cured or etched under the condition of optical radiation. In the present invention, the imprinting photoresist layer may form the exhausting ditches and exhausting grooves on the surface thereof through mechanical contact.

Epoxy resin is a kind of polymer with more than two epoxy groups, and is the polycondensation product of epoxy chloropropane and bisphenol A or polyalcohol. The epoxy resin has the outstanding characteristics of high bonding ability, and excellent chemical resistance, heat resistance and electrical insulation property, but due to the biggest disadvantages of low weather resistance, low impact-resistant strength and brittle texture, the epoxy resin is not used in the release film, and usually, the substrate layer is coated with PE to form the coating. However, the PE has low hardness and melting point, so it is difficult to form exhausting ditches or exhausting grooves on the surface thereof. Even after the exhausting ditches or exhausting grooves are formed in a special way, these exhausting ditches or exhausting grooves will disappear or be deformed in the subsequent thermocuring process. The high-temperature resistance of the epoxy resin usually reaches 180°C. In the absence of oxygen, the thermal decomposition temperature of the epoxy resin body is above 300°C. After the epoxy resin is used as the material of the coating to form the coating, it can be ensured that the shape of the exhausting ditches or exhausting grooves is kept stable at high temperature. However, due to the high hardness and insufficient flexibility, the brittleness of the epoxy resin will increase the difficulty of imprinting the exhausting ditches or exhausting grooves, the imprinting of the exhausting grooves is directly affected, and the adhesion based on the base material is poor. Therefore, it is necessary to modify the epoxy resin to improve the flexibility of the epoxy resin. According to the research of the present invention, the liquid acrylate oligomer has good compatibility with the epoxy resin, and the oligomer is embedded into the epoxy resin network by crosslinking with a curing agent during optical radiation, thereby achieving a good toughening effect. Therefore, in the present invention, an acrylic group is introduced to modify the epoxy resin, so that the epoxy resin has photochemical reactivity, and the flexibility of the modified epoxy resin is improved. Meanwhile, the original other properties of the epoxy resin are retained, and the introduction of the photosensitive group at the end broadens the application field of resin.

In the specific implementation solution, the photoresist prepolymer used in the present invention is a prepolymer obtained by performing copolymerization on the liquid acrylate oligomer and the bisphenol A (E-44) epoxy resin. Further, a copolymerization system of the liquid acrylate oligomer and the bisphenol A (E-44) epoxy resin of the present invention further includes 40-50% of reactive diluent, 0.1-0.75% of catalyst, 3-6% of adhesion accelerator and 1-5% of polymerization inhibitor based on the respective mass ratio of the reaction system. The liquid acrylate oligomer of the present invention is prepared by reacting the following components in parts by weight: 70-80 parts of butyl acrylate, 20-30 parts of glycidyl methacrylate, 3-5 parts of dibenzoyl peroxide and 1-2 parts of hydroquinone.

[Polymerization inhibitor]: the acrylate oligomer includes photosensitive group C=C double bonds, and is prone to produce polymerization after being heated. To inhibit the thermal polymerization, it is necessary to add the polymerization inhibitor in the process of preparing the photoresist prepolymer. As a further preferred solution, the polymerization inhibitor of the present invention adopts a phenol compound, and specifically may select but not limited to one or a mixture of more than two of hydroquinone, tert-butylcatechol, 2,6-butylated hydroxytoluene and p-methoxyphenol. The phenol compound is used as the polymerization inhibitor. In the prepolymerization, the polymerization inhibitor is oxidized into quinone first. To improve the efficiency of the thermal polymerization for inhibiting double bonds, oxygen may be introduced in the reaction process. Relative to other phenol compounds, during reaction under the same condition, the 2,6-butylated hydroxytoluene has a better polymerization inhibition effect at the early stage and has higher reaction speed. Therefore, as a preference, the 2,6-butylated hydroxytoluene polymerization inhibitor is used in the specific embodiment.

[Reactive diluent]: the reactive diluent of the present invention is UV monomer phenoxyethyl acrylate (EOEOA), dipropylene glycol diacrylate (DPGDA), trimethylolpropane triacrylate (TMPTA), hexanediol diacrylate (HDDA) and tripropylene glycol diacrylate (TPGDA). In the present invention, the reactive diluent mainly affects the flexibility of the coating, and this influence is related to the functionality of the used reactive diluent. Table 1 is the influence of the reactive diluents with different functionalities on the flexibility of the photoresist layer.

**Table 1: The influence of different reactive diluents on the flexibility of the photoresist layer**

| Sample | Functionality | Bending Axis |
|---|---|---|
| EOEOEA | 1 | 2 |
| DPGDA | 2 | 2 |
| TPGDA | 2 | 3 |
| TMPTA | 3 | 3 |

It can be seen from Table 1 that the linear structure of monofunctional EOEOA makes the rotation degree of freedom of a chain segment greater, and the chain segment is easy to curl and stretch, so the photoresist layer prepared from EOEOEA has high flexibility. The functionality of the bifunctional DPGDA is increased, and the crosslinking degree of the cured coating is increased. Meanwhile, the chain segment rotating freely is shortened, the strength is improved, and the flexibility is reduced. The tri-functional TMPTA has three photoactive groups which will cross-link in the radiation curing process, so that the cross-linking density is increased, and the flexibility of the cured film layer is reduced. Therefore, the flexibilities of the monofunctional and bifunctional coatings are more excellent than the flexibility of the tri-functional coating. In the present invention, EOEOEA or DPGDA is preferably used as the reactive diluent.

[Catalyst]: as a further preferred solution, the catalyst of the present invention adopts but is not limited to triethylamine or N, N-dimethylaniline, preferably the triethylamine. Compared with the N, N-dimethylaniline, the triethylamine, as the catalyst, has fewer side reactions and higher main reaction selectivity. Furthermore, the triethylamine is common and has lower price.

[Adhesion accelerator]: to improve the adhesion of the coating material on the base material, in the preferred solution, the adhesion accelerator is added in the photoresist prepolymer of the present invention. The adhesion accelerator adopts titanate with the general formula RO₍₄₋ₙ₎Ti(OX-R'Y)ₙ. N=(1, 3), RO- is hydrolyzable short-chain alkoxy, OX- is one of carboxyl, alkoxy, sulfonic group and phosphate group, which can determine the special functions of the titanate. For example, the sulfonic group endows the organic matter with certain thixotropy, pyrophosphoryl oxide has flame resistance and the property of enhancing adhesion; and selecting the OX- group can make the titanate have coupling and other special properties. R' is C₁₀-C₂₁ long-carbon alkane. The long-carbon alkane is relatively soft and can be bent and entangled with an organic polymer, so that the compatibility of the organic matter and the inorganic matter is improved, and the impact-resistant strength of the material is enhanced. Y is one of hydroxyl, amino, epoxy or alkyl containing double bonds. These groups are connected to the end of titanate molecules and can react with the organic matter to be combined together. These groups are further used as the reaction groups of the thermosetting polymer. When the groups are connected to the organic framework of titanium, the coupling agent and the organic material can perform chemical reaction for connection. For example, the double bonds can be crosslinked and cured with the unsaturated material, and the amino can be crosslinked with the epoxy resin. n also represents the functionality of the titanate, and n ranges from 1 to 3, so n can be adjusted as required to produce various effects on the organic matter. In this aspect, the flexibility is higher than that the trialkoxy monofunctional coupling agent like silane. Generally, organic titanate is used as an additive such as a coupling agent, a dispersing agent, a wetting agent, an adhesive, a crosslinking agent and a catalyst. However, in the present invention, the organic titanate has strong affinity with the polyester film of the base material, is used as an adhesion accelerator and can generate ester exchange with the polyester groups, thereby enhancing the adhesion of the coating on the surface of the base material and achieving an anchored state.

[Functional additive]: as a further preferred solution, the functional additive of the present invention is one or a mixture of more than two of an acrylic leveling agent, an organosilicon leveling agent and a fluorocarbon leveling agent. Preferably, the leveling agent is selected from one or a mixture of more than two of EFKA3883, EFKA3886, EFKA3600, BYK366, BYK333, BYK307 and TEGOGlide410.

[Epoxy resin]: the epoxy resin used in the present invention refers to the general term of a kind of polymer with the molecule containing more than two epoxy groups, preferably, epoxy resin bisphenol A (E-44).

**[Curing method]**: the method of forming the photoresist layer adopts optical radiation curing, preferably, ultraviolet (UV) curing.

In the present invention, further, in the ultraviolet curing process, a photoinitiator is added in the reaction system so as to shorten the radiation curing time and promote the crosslinking reaction of the curing process. The mass ratio of the photoinitiator in the prepolymer is 1.2-2.5%. Preferably, the photoinitiator of the present invention is one or a mixture of more than two of phenylacetophenone, 2, 4-dihydroxy benzophenone, acyl phosphorus oxide, alkylphenol, diaryl iodonium salt and alkyl iodonium salt. Specifically, the photoinitiator may select one or more of the photoinitiators with the product names produced by German Evonik Company: PhotoiniciatorA18, IHT-PI185, IHT-PI907, Irgacure651, Irgacure184, Irgacure369, Irgacure754, Irgacure2022, Darocur1173 and DarocurMBF, and PhotoiniciatorA18 has the better effect.

**[Anchoring force]**: the anchoring force of the imprinting photoresist layer of the present invention on the base material is 0-1.

**[Hardness]**: to imprint or press the exhausting ditches or exhausting grooves on the photoresist layer and to make the exhausting ditches or exhausting grooves not be deformed and not collapse in the subsequent thermocuring process, the hardness of the coating formed by curing is very important. Therefore, in the present invention, the hardness of the photoresist layer is not less than 2H with reference to the hardness of the photoresist layer measured by the GB/T6739-2006 pencil test method.

**[Release agent and release force]**: as a further preferred solution, the imprinting photoresist release film material with an exhausting function of the present invention further includes a release agent layer, and the surface of the imprinting photoresist layer is coated with the release agent layer. The release agent used by the release agent layer is a free radical photocuring release agent, and the components of the release agent layer include polysiloxane. The polysiloxane specifically may be selected from acrylate-based polysiloxane and hyperbranched polysiloxane or a mixture of the two. When the mixture of the acrylate-based polysiloxane and the hyperbranched polysiloxane is used, it is most suitable for mixing the acrylate-based polysiloxane and the hyperbranched polysiloxane according to the mass ratio of 1:1. The acrylate-based polysiloxane is preferably selected from one or a mixture of more than two of the product names of TEGO@RC902 and TEGO@RC922 produced by German Evonik Specialty Chemical Company, the products name of SilcoleaseUVPoly110, SilcoleaseUVPoly112 and SilcoleaseUVPoly118 produced by France Elkem Organosilicon Company, the product name of Coatsil7602 produced by American Momentive Company or the product names of X-62-7622 and X-62-7629 produced by Japanese Shin-Etsu Company in any ratio. The acrylate-based polysiloxane with the best release effect is the acrylate-based polysiloxane with the product name of TEGO@RC902 produced by German Evonik Specialty Chemical Company. The hyperbranched polysiloxane is preferably one or a mixture of more than two of the product names of TEGO^{@}RC715, TEGO^{@}RC711, TEGO^{@}RC722 and TEGO^{@}RC706 produced by German Evonik Specialty Chemical Company, the product names of SilcoleaseUVAdd152, SilcoleaseUVAdd153 and SilcoleaseUVPC900 produced by France Elkem Organosilicon Company or the product names of X-62-7661 and X-62-7989 produced by Japanese Shin-Etsu Company or KF2005. The hyperbranched polysiloxane with the best effect is the hyperbranched polysiloxane with the product name of X-62-7989 produced by Japanese Shin-Etsu Company.

In the specific implementation solution, to further control the release force of the release film material, the dry coating amount of the polysiloxane release agent is 0.5-2.5 g/m². In the research process of the implementation solution of the present invention, the silicon coating amount is related to the depth of the exhausting ditches or exhausting grooves; in some solutions with the nanometer depth, the dry coating amount is 0.5 g/m²m; and in some solutions with the exhausting ditches or grooves having the depth of 30 um, the dry coating amount is 2.5 g/m², because the depth of the exhausting grooves is easy to consume the release agent.

The release force is a force for peeling off the viscous material or pressure-sensitive adhesive product from the release film material with the exhausting function of the present invention. The exhausting ditches or exhausting grooves of the adhesive layer of the viscous material or pressure-sensitive adhesive product are formed by the release film material with the exhausting function through bonding and copying, so the release force of the release film material should not be too small. Too small release force will lead to the sliding dislocation of the adhesive layer on the lower surface of the surface material and the release film material after bonding to form the disordered textures of the exhausting ditches or grooves, thereby affecting the exhausting function. Too large release force will lead to the excessive force required when the viscous material or pressure-sensitive adhesive product is peeled off from the release film material, even the product cannot be peeled off and is failure in releasing, thereby causing product obsolescence. In the research of the present invention, the release force of 30-80 g/25 mm can be accurately adjusted by a release force regulator. The release force regulator may be 7210, SP7201, 7200 and SL40 of Dow SYL-OFF; and 6-15 % and 16-25 % based on parts by mass are added according to different release force requirements.

The coating treatment and ultraviolet or electronic beam curing process of the release agent layer of the present invention is preferably performed in the inert atmosphere, and the inert atmosphere is preferably nitrogen.

In a further preferred solution of the present invention, the component of the release agent may also be blended with the photoresist prepolymer, and the polymer film is coated with the mixture by a coating machine, the exhausting ditches or exhausting grooves are imprinted by a mechanical roll, and UV radiation curing is performed to form the imprinting photoresist layer with the exhausting ditches or exhausting grooves. Since the release agent is added, the obtained photoresist layer has the release force, and can be peeled off from the adhesive layer on the lower surface of the surface material in the application. In the present invention, the release force of the imprinting photoresist release film material after coating is 30-80 g/25 mm.

As a further preferred solution, the exhausting ditches of the present invention penetrate through or do not penetrate through the photoresist layer.

The present invention provides a car cover, including a surface material, an adhesive layer anchored on a lower surface of the surface material, and a release film bonded to the adhesive layer. The release film is the imprinting photoresist release film material with an exhausting function of the present invention; and after the surface material and the adhesive layer anchored on the lower surface of the surface material are bonded to the imprinting photoresist release film material, the adhesive layer on the lower surface of the surface material is imprinted by the bumps on the surface of the imprinting photoresist layer, and the exhausting ditches or exhausting grooves matched therewith are formed in the adhesive layer. In the present invention, the car cover refers to a film layer attached to the surface of the car body for protecting car paint. The car cover is transparent and does not cover the color of the car.

The present invention provides a wrap film, including a surface material, an adhesive layer anchored on a lower surface of the surface material, and a release film bonded to the adhesive layer. The release film is the imprinting photoresist release film material with an exhausting function of the present invention; and after the surface material and the adhesive layer anchored on the lower surface of the surface material are bonded to the imprinting photoresist release film material, the adhesive layer on the lower surface of the surface material is imprinted by the bumps on the surface of the imprinting photoresist layer, and the exhausting ditches or exhausting grooves matched therewith are formed in the adhesive layer. In the present invention, the wrap film refers to a film attached to the car body, can cover the color of the original car paint of the car body, and can change the color of the car body without damaging the original car paint.

**Embodiment 1**
an imprinting photoresist release film material with an exhausting function includes:
a substrate layer, having an upper surface and a lower surface; and further comprising:
a photoresist prepolymer. The upper surface or/and the lower surface of the substrate layer is/are coated with the photoresist prepolymer; while the photoresist prepolymer is cured through optical radiation to form an imprinting photoresist layer, the surface of the imprinting photoresist layer is imprinted to form a plurality of exhausting ditches or exhausting grooves;
the plurality of exhausting ditches or exhausting grooves divide the imprinting photoresist layer into a plurality of bumps; and the bumps imprint grooves matched therewith on the imprinting photoresist layer through mechanical contact.

Further, the imprinting photoresist release film material with the exhausting function of the embodiment is prepared by the following method:
a photoresist layer coating step: coating the upper surface or lower surface of the substrate layer with a photoresist prepolymer coating;
a coating curing step: curing the photoresist prepolymer coating coated on the surface of the substrate layer through radiation to form a radiated photoresist layer;
an exhausting ditch or exhausting groove forming step: transferring a transfer film with a bumped structure or a reticulated structure to the surface of the photoresist layer to form exhausting ditches or exhausting grooves; and
a transfer film peeling step: after transferring, peeling off the transfer film from the photoresist layer to obtain an imprinting photoresist release film material with the exhausting ditches or exhausting grooves.

In this embodiment, before the photoresist layer coating step, the photoresist prepolymer is prepared first, including the following specific steps:
preparation of a liquid acrylate oligomer: (1) benzoyl peroxide was diluted with ethyl acetate in a volume which is 5 times that of the ethyl acetate for later use; (2) butyl acrylate and glycidyl methacrylate were fed into a reactor at one time; (3) under the protection of nitrogen, water bath was heated to 85°C, the benzoyl peroxide diluted by the ethyl acetate was added dropwise at the beginning, and dodecyl mercaptan was added in several times; and (4) hydroquinone was added after 5 hours of reaction, monomers and solvents for microreaction were removed after the reaction was completed, and drying was performed to a constant weight to obtain the liquid acrylate oligomer.

Preparation of the photoresist prepolymer: (1) the liquid acrylate oligomer and a catalyst were mixed for later use; (2) epoxy resin and a polymerization inhibitor were sequentially put into a reaction device according to the formula ratio, a reactive diluent, a curing accelerator and a photoinitiator were added, mixed liquid of the catalyst and the liquid acrylate oligomer was added slowly by a dropping funnel, then heating, stirring and slow heating were performed, the reaction temperature was controlled to 110°C, and when the acid value of the reactants were reduced to 3 mgKOH/g, the reaction ended to obtain the photoresist prepolymer.

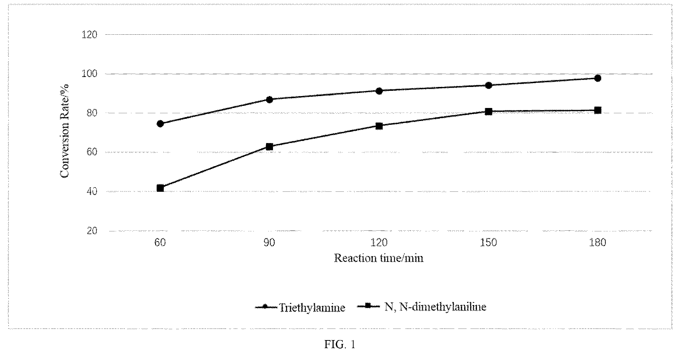

In the above embodiments, to discuss the relationship between the catalyst and the use amount thereof and the conversion rate of the photoresist prepolymer, the inventor used triethylamine and N, N-dimethylaniline as the catalyst first to perform reaction according to the above steps and calculate the conversion rate for comparison. The results are shown in FIG. 1.

It can be seen from FIG. 1 that when the reaction time is 180 minutes, the conversion rate may reach 97.8% if the triethylamine is used as the catalyst, and the conversion rate is only 81.4% if the N, N-dimethylaniline is used as the catalyst. This is because the triethylamine has fewer side reactions and higher selectivity of main reaction than the N,N- dimethylbenzylamine as the catalyst. Furthermore, the triethylamine is relatively common and has low price, so preferably, the triethylamine is preferably used as the catalyst in the present invention. The use amount of the catalyst affects the reaction time. If the use amount is too small, the required time is long and the catalytic effect cannot be achieved. If the use amount is too much, the color of the product will become darker and the heat stability will decrease. It is found in the experiment that when the use amount of the triethylamine is 0.25%-0.75%, the reaction time and the conversion rate can be controlled in a better range. Preferably, the use amount of the triethylamine is 0.5%. In many implementation solutions, the use amount of the triethylamine is preferably 0.55%.

Based on the above embodiments, further, to understand the influence of the polymerization type on the conversion rate, the present invention selects the polymerization method. In the experiment, the inventor compared two polymerization methods of bulk polymerization and solution polymerization to find the most preferred implementation solution. Table 2 is the research result of bulk polymerization and solution polymerization.

**Table 2: the influence of the reaction type on the reaction process**

| Reaction Type | *Reaction Temperature °C* | Time front Reaction to Endpoint/min | Conversion Rate/% |
|---|---|---|---|
| Solution polymerization | 100 | 180 | 92.71 |
| Bulk polymerization | 110 | 180 | 98.14 |

It can be seen from the result of Table 2 that although the bulk polymerization requires higher reaction temperature, the conversion rate is greatly increased, so the bulk polymerization method is preferred in the present invention.

Based on the above embodiment solution, the present inventor further discussed the influence of the charging methods on the properties of the photoresist prepolymer product and chose two charging methods:(a) the epoxy resin bisphenol A (E-44) and the catalyst were mixed first and then the acrylate oligomer was added for reaction, and a high system viscosity, even gelation phenomenon occurs in this method; and (b) the acrylate oligomer, the catalyst and the polymerization inhibitor were mixed uniformly and then the mixture was added in the epoxy resin slowly and dropwise, and the obtained product has high flowability and is yellowish. The results are shown in Table 3.

**Table 3: the influence of the charging method on the reaction process**

| Charging Method | Color | Stability | Viscosity/Pa.s |
|---|---|---|---|
| a | Redish brown | Easy to gel | 34.36 |
| b | Pale yellow | Relatively stable | 21.47 |

The reason for the above results is that there are two competitive reactions in the reaction system under the action of the catalyst: (1) autopolymerization of epoxy groups; and (2) the esterification reaction of carboxyl and epoxy groups. Adding the catalyst first will lead to obvious autopolymerization of the epoxy groups, and the molecular weight is too large to obtain the required target product. After being mixed, the catalyst and the acrylic acid can be neutralized and salified to form a carboxylate anion active group, thereby inhibiting the occurrence of side reactions and significantly increasing the reaction rate of ring-opening esterification of the epoxy groups.

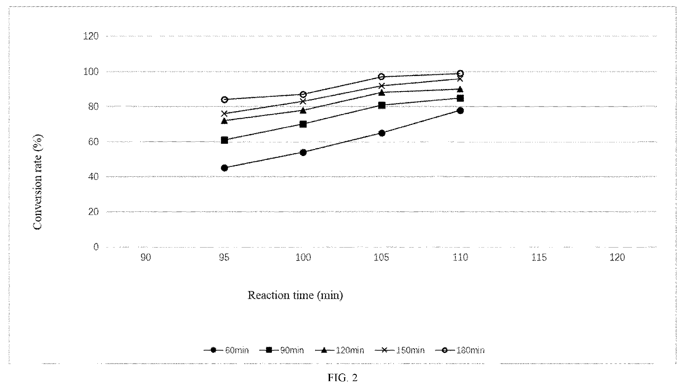

Based on the above embodiment solutions, the inventor further studied the influence of the reaction temperature and time on the conversion rate of the photoresist prepolymer, and investigated the change of the reaction system with time under different reaction temperatures and time. The results are shown in FIG. 2.

The results in FIG. 2 show that in the initial state of the reaction, the conversion rate is increased rapidly with the increase of time, and the increasing trend slows down after 150 minutes. The reaction degree reaches 90% when the reaction is performed for 90 minutes at 110°C, while the reaction degree reaches 84% when the reaction is performed for 180 minutes at 95°C. When the reaction time reaches 180 minutes, the conversion rates at 95°C, 100°C and 105°C are respectively 84%, 87% and 97%. In particular, the reaction degree at 110°C has reached 99%, and the esterification is basically completed. According to the research of the present invention, the reaction temperature plays a decisive role in the reaction rate. Due to the increase of the reaction temperature, the number of molecules higher than activation energy is increased, so the number of active molecules is increased and the reaction rate is increased. However, if the temperature is too high, the energy consumption will be high, and the degree of other side reactions will also be increased. Therefore, the reaction temperature is suitably controlled at 110°C.

According to the above results, the modified epoxy acrylic acid mixture prepared from the bisphenol A epoxy resin (E-44) and the acrylate oligomer, the bulk polymerization method is adopted, the triethylamine is used as the catalyst, the use amount of the catalyst is 0.6%, the reaction temperature is 110°C, the reaction time is 3 hours, and the conversion rate of the photoresist prepolymer can reach 98% or more.

Based on the above embodiment solutions, the inventor of the present invention further discussed the influence of the composition of the coating material on the hardness and flexibility of the photoresist layer. The relationship between the hardness and flexibility of the coating and the composition of the coating material is shown in Table 4.

**Table 4: The relationship between the properties of the photoresist layer and the composition of the coating material**

| 75 parts of BA and 25 parts of GMA form the oligomer | Epoxy resin E-44 | DPGDA | EOEOA | Flexibility Spindle Number | Pencil Hardness H |
|---|---|---|---|---|---|
| 40 | 10 | 25 | 25 | 6 | 2 |
| 30 | 20 | 25 | 25 | 5 | 2 |
| 25 | 25 | 25 | 25 | 5 | 3 |
| 20 | 30 | 25 | 25 | 4 | 4 |
| 15 | 35 | 20 | 30 | 3 | 5 |
| 10 | 40 | 15 | 35 | 2 | 6 |
| 0 | 50 | 25 | 25 | 1 | 7 |

The results of Table 4 show that with the increase of the use amount of the epoxy resin in the coating system, the hardness of the coating film after the coating is cured increases, but the flexibility decreases; and the use amount of the acrylate oligomer is increased, and the flexibility is enhanced. In the experiment, the inventor further found that the proper composition of the reactive diluent monomer can obtain the required coating hardness and the corresponding flexibility.

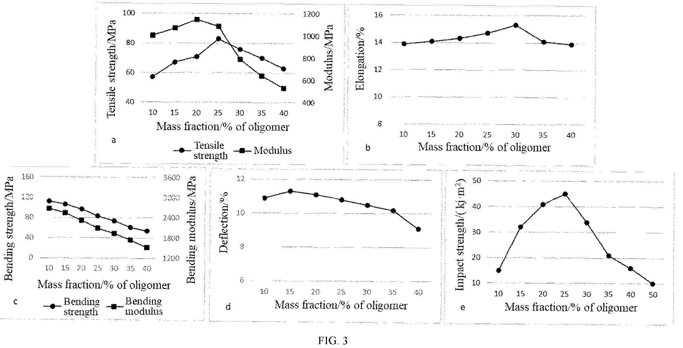

Based on the solution of Embodiment 1, the inventor further discussed the influence of the use amount of the acrylate oligomer on the mechanical property of the epoxy acrylic acid prepolymer coating. The acrylate oligomer with the mass ratio of BA to GMA of 75:25 is selected, and the influence of the use amount on the mechanical property of the modified epoxy resin is shown in FIG. 3.

The results in FIG. 3 show that with the increase of the using amount of the oligomer, the tensile strength and the tensile modulus of the modified epoxy resin are increased first and then reduced, and the position of the peak appears between 20% and 25%; when the use amount exceeds 30%, the tensile strength and the tensile modulus show a descending trend; and when the use amount exceeds 40%, the tensile strength and the tensile modulus are reduced by about one time. This experiment shows that the elongation at break is higher than that of the pure epoxy system, the properties have little change at 10% and 40%, and the property is obviously improved compared with the pure epoxy resin when the use amount is 30% (as shown in FIG. 3a and FIG. 3b). With the increase of the use amount of the oligomer, the bending strength and the bending modulus of the modified epoxy resin are reduced gradually; and the deflection is higher than that of the pure epoxy resin (as shown in FIG. 3c and FIG. 3d). The impact strength of the modified epoxy resin is greatly improved compared with the epoxy resin. With the increase of the use amount of the oligomer, the impact strength is increased first and then reduced, and the peak value appears when the use amount is 25% (as shown in FIG. 3e). In general, when the use amount of the oligomer is 10%, the toughening effect begins to appear; when the use amount of the oligomer exceeds 15%, the toughening effect is significant; and when the use amount of the oligomer reaches 25%, the toughening effect and hardness reach a high balanced state. Therefore, in the present invention, preferably, when the use amount (based on mass percentage) of the acrylate oligomer in the polymerization system is 10%-30%, the hardness and flexibility of the obtained imprinting photoresist can further ensure the formation of the exhausting ditches or exhausting grooves, and a stable exhausting structure can be formed on the surface material in the later stage.

In another embodiment, the inventor adopted the oligomer with the mass ratio of BA to GMA of 70:30, and investigated the influence of the use amount of the acrylate oligomer on the scratching resistance of the coating after the photoresist prepolymer is cured. The results are shown in Table 5.

**Table 5: the influence of the content of the oligomer in the prepolymer system on the hardness and scratching resistance of the photoresist layer**

| BA and GMA form the oligomer | Epoxy resin E-44 | Reactive diluent DPGDA/EOEO A | Initiator and aid | Hardness (H) | Scratching resistance (times) |
|---|---|---|---|---|---|
| 40 | 10 | 40 | 10 | 2 | 8 |
| 30 | 20 | 40 | 10 | 2 | 10 |
| 25 | 25 | 40 | 10 | 3 | 10 |
| 20 | 30 | 40 | 10 | 4 | 6 |
| 15 | 35 | 40 | 10 | 5 | 5 |

The results of Table 5 show that when the content of the oligomer reaches 25%, the toughening effect, the hardness and the scratching resistance reach a high balanced state.

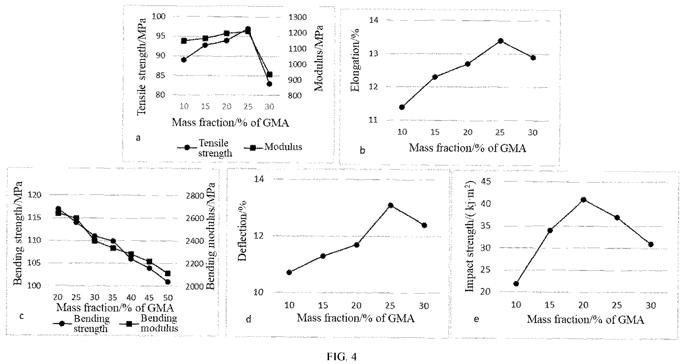

Further, based on Embodiment 1, in the present invention, the influence of the use amount of GMA on the mechanical property of the modified epoxy acrylic acid prepolymer was further discussed, where the mass ratio of the acrylate oligomer in the system is 20%. The results are shown in FIG. 4.

The results of FIG. 4 show that with the increase of the GMA content of the oligomer, the tensile strength and the tensile modulus of the modified epoxy resin are increased first and then reduced, reach the maximum when the content is 25%, and are significantly higher than the tensile strength and the tensile modulus of the epoxy resin; when the GMA content is 20%, the tensile strength and the tensile modulus are higher than those of the pure epoxy resin; the elongation at break of the modified epoxy resin is higher than that of the pure epoxy resin and is gradually increased with the increase of the GMA content (as shown in FIG. 4a and FIG. 4b); with the increase of the GMA content, the bending strength, the bending modulus and the deflection of the modified epoxy resin reach the peak values and then are reduced, and the peak values are respectively at 25%, 20% and 25%; however, from the bending property test, the bending strength and the bending modulus of the modified epoxy resin are reduced compared with the pure epoxy resin, and the deflection is higher than that of the pure epoxy resin (as shown in FIG. 4c and FIG. 4d); and the impact strengths of the oligomer modified epoxy resin with different GMA contents are greatly enhanced compared with the pure epoxy resin, and the peak value is reached when the GMA content is 20%, (as shown in FIG. 4e). In general, in the prepolymerization system, when the use amount of GMA exceeds 10%, the toughening effect is achieved; when the use amount is 15%, the toughening effect is significant; and when the use amount of GMA is 20%-30%, a good toughening effect is achieved and the best state is reached. Therefore, in the present invention, preferably, in the prepolymerization, the flexibility of the epoxy resin can be improved when the use amount of GMA is 10%-40%. In a further preferred solution, the use amount of GMA in the prepolymerization system is 20%-30%.

Based on Embodiment 1, the inventor further discussed the influence of the adhesion accelerator on the adhesion of the photoresist layer on the surface of the substrate layer (the adhesion is measured by an ISO 2409-2007 cross-cut test). The oligomer with the mass ratio of BA to GMA of 75:25 is adopted, the ratio and results of the main components in the photoresist prepolymer are shown in Table 6, and in each group of experiment, the unlisted components are added to 100%in the system except the main components listed in the table.

**Table 6: the influence of the adhesion accelerator on the adhesion property of the coating**

| 75 parts of BA and 25 parts of GMA form the oligomer | Epoxy resin E-44 (%) | Reactive diluent DPGDA/EOE | Titanate accelerator % | Har dness (H) | Scratchi ng resistance (times) | Adhesion test |
|---|---|---|---|---|---|---|
| 40 | 20 | 40 | 0 | 1 | 5 | 4 |
| 40 | 10 | 40 | 2 | 1 | 8 | 2 |
| 30 | 20 | 40 | 3 | 2 | 11 | 1 |
| 25 | 25 | 40 | 4 | 3 | 11 | 1 |
| 20 | 30 | 40 | 4 | 4 | 6 | 1 |
| 15 | 35 | 40 | 5 | 5 | 5 | 1 6 |
| 0 | 50 | 45 | 5 | 6 | 2 | |

The adhesion accelerator of the present invention has good affinity on the surface of the polymer film, and the organic titanate is easy to perform ester exchange with the polymer film, particularly the polyester group, so that the adhesion of the coating on the surface of the polymer film is enhanced.

## Claims

1. An imprinting photoresist release film material with an exhausting function, comprising:
a substrate layer, having an upper surface and a lower surface; and further comprising:
a photoresist prepolymer, **characterized in that**
the photoresist prepolymer is a prepolymer obtained through copolymerization of a liquid acrylate oligomer and epoxy resin which is a polymer with more than two epoxy groups and is a polycondensation product of epoxy chloropropane and bisphenol A, wherein
the liquid acrylate oligomer is prepared by reacting the following components in parts by weight: 70-80 parts of butyl acrylate, 20-30 parts of glycidyl methacrylate, 3-5 parts of dibenzoyl peroxide and 1-2 parts of hydroquinone;
and wherein the upper surface or/and the lower surface of the substrate layer is/are coated with the photoresist prepolymer; while the photoresist prepolymer is cured through optical radiation to form an imprinting photoresist layer, the surface of the imprinting photoresist layer is imprinted through mechanical contact to form a plurality of exhausting ditches or exhausting grooves; and the plurality of exhausting ditches or exhausting grooves divide the imprinting photoresist layer into a plurality of bumps.

2. The imprinting photoresist release film material with an exhausting function according to claim 1, **characterized in that** the surface of the photoresist layer is imprinted through imprinting of a mechanical roll or transferring of a transfer film to form the exhausting ditches or exhausting grooves.

3. The imprinting photoresist release film material with an exhausting function according to claim 1, **characterized in that** a copolymerization system of the liquid acrylate oligomer and the epoxy resin which is a polymer with more than two epoxy groups and is a polycondensation product of epoxy chloropropane and the bisphenol A further comprises 40-50% of reactive diluent, 0.1-0.75% of catalyst, 3-6% of adhesion accelerator and 1-5% of polymerization inhibitor based on the respective mass ratio of the reaction system.

4. The imprinting photoresist release film material with an exhausting function according to claim 1, **characterized in that** the pencil hardness of the imprinting photoresist layer is greater than or equal to 2H, wherein a method for measurement of pencil hardness refers to the GB/T6739-2006 pencil test method.

5. The imprinting photoresist release film material with an exhausting function according to claim 1, **characterized in that** the distance between every two adjacent exhausting ditches or exhausting grooves is 200-600 µm, the width of the exhausting ditches or exhausting grooves is 6-60 µm, and the depth of the exhausting ditches or exhausting grooves is 3-30 µm.

6. The imprinting photoresist release film material with an exhausting function according to claim 1, further comprising a release layer formed by coating the imprinting photoresist layer with a polysiloxane release agent, **characterized in that** the dry coating amount of the polysiloxane release agent is 0.5-2.5 g/m².

7. The imprinting photoresist release film material with an exhausting function according to any one of claims 1 to 6, **characterized in that** the substrate layer is one of a polyethylene glycol terephthalate film, a polyimide film, a polypropylene film and a polyvinyl chloride film, or one of homopolymers, copolymers or derivatives of polyethylene glycol terephthalate, polyethylene glycol terephthalate, polypropylene and polyvinyl chloride.

8. A preparation method for the imprinting photoresist release film material with an exhausting function according to any one of claims 1 to 6, comprising:
preparing the liquid acrylate oligomer: mixing 70-80 parts of butyl acrylate, 20-30 parts of glycidyl methacrylate, 3-5 parts of dibenzoyl peroxide and 1-2 parts of hydroquinone, and heating and polymerizing the mixture in water bath to obtain the liquid acrylate oligomer;
preparing the photoresist prepolymer: introducing the epoxy resin which is a polymer with more than two epoxy groups and is a polycondensation product of epoxy chloropropane and bisphenol A into the liquid acrylate oligomer and performing copolymerization to obtain the photoresist prepolymer;
performing coating with the photoresist prepolymer: coating the upper surface or lower surface of the substrate layer with the photoresist prepolymer; and
curing and imprinting the exhausting ditches or exhausting grooves: while performing optical radiation on the coated photoresist prepolymer to form the imprinting photoresist layer, forming the exhausting ditches or exhausting grooves on the surface of the imprinting photoresist layer by an engraving roll with a bumped structure.

9. The preparation method according to claim 8, further comprising:
performing coating with the release agent: coating the surface of the imprinting photoresist layer with the release layer formed by a siloxane release agent, the dry coating amount of the siloxane release agent being 0.5-2.5 g/m².

10. Use of the imprinting photoresist release film material with an exhausting function according to any one of claims 1 to 6 in a pressure-sensitive adhesive material, **characterized in that** the pressure-sensitive adhesive material is bonded to the release film material, and the exhausting ditches or exhausting grooves are formed in the surface of the pressure-sensitive adhesive material through copying of the release film.

11. Use of the imprinting photoresist release film material with an exhausting function according to any one of claims 1 to 6 in a car cover and a wrap film.

12. A car cover, comprising a surface material, an adhesive layer anchored on a lower surface of the surface material, and a release film bonded to the adhesive layer, **characterized in that** the release film is the imprinting photoresist release film material with an exhausting function according to any one of claims 1 to 6; and after the surface material and the adhesive layer anchored on the lower surface of the surface material are bonded to the imprinting photoresist release film material, the adhesive layer on the lower surface of the surface material is imprinted by the bumps on the surface of the imprinting photoresist layer, and the exhausting ditches or exhausting grooves matched therewith are formed in the adhesive layer.

## Patentansprüche

1. Ein Präge-Photoresist-Trennfilmmaterial mit einer Entlüftungsfunktion, umfassend:
eine Substratschicht mit einer oberen Oberfläche und einer unteren Oberfläche; und ferner umfassend:
einen Photoresist-Präpolymer, **dadurch gekennzeichnet, dass**
der Photoresist-Präpolymer ein Präpolymer ist, das durch Copolymerisation eines flüssigen Acrylat-Oligomers und eines Epoxidharzes erhalten wird, wobei das Epoxidharz ein Polymer mit mehr als zwei Epoxidgruppen ist und ein Polykondensationsprodukt aus Epoxychlorpropan und Bisphenol A ist, wobei
das flüssige Acrylat-Oligomer durch Reaktion der folgenden Komponenten in Gewichtsteilen hergestellt wird: 70-80 Teile Butylacrylat, 20-30 Teile Glycidylmethacrylat, 3-5 Teile Dibenzoylperoxid und 1-2 Teile Hydrochinon;
und wobei die obere Oberfläche oder/und die untere Oberfläche der Substratschicht mit dem Photoresist-Präpolymer beschichtet ist/sind; wobei das Photoresist-Präpolymer durch optische Strahlung gehärtet wird, um eine Präge-Photoresistschicht zu bilden, deren Oberfläche der Präge-Photoresistschicht durch mechanischen Kontakt geprägt wird, um mehrere Entlüftungsrillen oder Entlüftungsnuten zu bilden; und wobei die mehreren Entlüftungsrillen oder Entlüftungsnuten die Präge-Photoresistschicht in mehrere Erhebungen unterteilen.

2. Präge-Photoresist-Trennfilmmaterial mit einer Entlüftungsfunktion nach Anspruch 1, **dadurch gekennzeichnet, dass** die Oberfläche der Photoresistschicht durch Prägen mit einer mechanischen Walze oder durch Übertragen eines Transferfilms geprägt wird, um die Entlüftungsrillen oder Entlüftungsnuten zu bilden.

3. Präge-Photoresist-Trennfilmmaterial mit einer Entlüftungsfunktion nach Anspruch 1, **dadurch gekennzeichnet, dass** ein Copolymerisationssystem des flüssigen Acrylat-Oligomers und des Epoxidharzes, das ein Polymer mit mehr als zwei Epoxidgruppen ist und ein Polykondensationsprodukt aus Epoxychlorpropan und Bisphenol A ist, ferner 40-50 % Reaktivverdünner, 0,1-0,75 % Katalysator, 3-6 % Haftvermittler und 1-5 % Polymerisationsinhibitor jeweils bezogen auf das Massenverhältnis des Reaktionssystems umfasst.

4. Präge-Photoresist-Trennfilmmaterial mit einer Entlüftungsfunktion nach Anspruch 1, **dadurch gekennzeichnet, dass** die Bleistifthärte der Präge-Photoresistschicht größer oder gleich 2H ist, wobei ein Verfahren zur Messung der Bleistifthärte auf das Bleistifttestverfahren gemäß GB/T6739-2006 Bezug nimmt.

5. Präge-Photoresist-Trennfilmmaterial mit einer Entlüftungsfunktion nach Anspruch 1, **dadurch gekennzeichnet, dass** der Abstand zwischen jeweils zwei benachbarten Entlüftungsrillen oder Entlüftungsnuten 200-600 µm beträgt, die Breite der Entlüftungsrillen oder Entlüftungsnuten 6-60 µm beträgt und die Tiefe der Entlüftungsrillen oder Entlüftungsnuten 3-30 µm beträgt.

6. Präge-Photoresist-Trennfilmmaterial mit einer Entlüftungsfunktion nach Anspruch 1, ferner umfassend eine Trennschicht, die durch Beschichten der Präge-Photoresistschicht mit einem Polysiloxan-Trennmittel gebildet ist, **dadurch gekennzeichnet, dass** die Trockenbeschichtungsmenge des Polysiloxan-Trennmittels 0,5-2,5 g/m² beträgt.

7. Präge-Photoresist-Trennfilmmaterial mit einer Entlüftungsfunktion nach einem der Ansprüche 1 bis 6, **dadurch gekennzeichnet, dass** die Substratschicht ein Polyethylenterephthalat-Film, ein Polyimid-Film, ein Polypropylen-Film oder ein Polyvinylchlorid-Film ist oder eines von Homopolymeren, Copolymeren oder Derivaten von Polyethylenterephthalat, Polyimid, Polypropylen und Polyvinylchlorid ist.

8. Ein Herstellungsverfahren für das Präge-Photoresist-Trennfilmmaterial mit einer Entlüftungsfunktion nach einem der Ansprüche 1 bis 6, umfassend:
Herstellen des flüssigen Acrylat-Oligomers: Mischen von 70-80 Teilen Butylacrylat, 20-30 Teilen Glycidylmethacrylat, 3-5 Teilen Dibenzoylperoxid und 1-2 Teilen Hydrochinon und Erhitzen und Polymerisieren der Mischung im Wasserbad, um das flüssige Acrylat-Oligomer zu erhalten;
Herstellen des Photoresist-Präpolymers: Einbringen des Epoxidharzes, das ein Polymer mit mehr als zwei Epoxidgruppen ist und ein Polykondensationsprodukt aus Epoxychlorpropan und Bisphenol A ist, in das flüssige Acrylat-Oligomer und Durchführen der Copolymerisation, um das Photoresist-Präpolymer zu erhalten;
Durchführen der Beschichtung mit dem Photoresist-Präpolymer: Beschichten der oberen Oberfläche oder der unteren Oberfläche der Substratschicht mit dem Photoresist-Präpolymer; und
Härten und Prägen der Entlüftungsrillen oder Entlüftungsnuten: während optische Strahlung auf das beschichteten Photoresist-Präpolymer durchgeführt wird, um die Präge-Photoresistschicht zu bilden, Bilden der Entlüftungsrillen oder Entlüftungsnuten auf der Oberfläche der Präge-Photoresistschicht durch eine Gravurwalze mit einer Erhebungsstruktur.

9. Herstellungsverfahren nach Anspruch 8, ferner umfassend:
Durchführen der Beschichtung mit dem Trennmittel: Beschichten der Oberfläche der Präge-Photoresistschicht mit der Trennschicht, die durch ein Siloxan-Trennmittel gebildet ist, wobei die Trockenbeschichtungsmenge des Siloxan-Trennmittels 0,5-2,5 g/m² beträgt.

10. Verwendung des Präge-Photoresist-Trennfilmmaterials mit einer Entlüftungsfunktion nach einem der Ansprüche 1 bis 6 in einem druckempfindlichen Klebematerial, **dadurch gekennzeichnet, dass** das druckempfindliche Klebematerial mit dem Trennfilmmaterial verbunden ist und die Entlüftungsrillen oder Entlüftungsnuten in der Oberfläche des druckempfindlichen Klebematerials durch Abformen des Trennfilms gebildet werden.

11. Verwendung des Präge-Photoresist-Trennfilmmaterials mit einer Entlüftungsfunktion nach einem der Ansprüche 1 bis 6 in einer Fahrzeugabdeckfolie und einer Wrapping-Folie.

12. Eine Fahrzeugabdeckfolie, umfassend ein Oberflächenmaterial, eine an einer unteren Oberfläche des Oberflächenmaterials befestigte Klebeschicht und einen mit der Klebeschicht verbundenen Trennfilm, **dadurch gekennzeichnet, dass** der Trennfilm das Präge-Photoresist-Trennfilmmaterial mit einer Entlüftungsfunktion nach einem der Ansprüche 1 bis 6 ist; und nachdem das Oberflächenmaterial und die an der unteren Oberfläche des Oberflächenmaterials befestigte Klebeschicht mit dem Präge-Photoresist-Trennfilmmaterial verbunden sind, wird die Klebeschicht an der unteren Oberfläche des Oberflächenmaterials durch die Erhebungen auf der Oberfläche der Präge-Photoresistschicht geprägt, und die damit korrespondierenden Entlüftungsrillen oder Entlüftungsnuten werden in der Klebeschicht gebildet.

## Revendications

1. Matériau de film antiadhésif de résine photosensible d'impression ayant une fonction d'évacuation, comprenant :
une couche substrat, présentant une surface supérieure et une surface inférieure ; et comprenant en outre :
un prépolymère de résine photosensible, **caractérisé en ce que**
le prépolymère de résine photosensible est un prépolymère obtenu par copolymérisation d'un oligomère d'acrylate liquide et d'une résine époxy qui est un polymère avec plus de deux groupes époxy et est un produit de polycondensation d'époxy chloropropane et de bisphénol A, dans lequel
l'oligomère d'acrylate liquide est préparé par réaction des composants suivants en parties en poids : 70-80 parties d'acrylate de butyle, 20-30 parties de méthacrylate de glycidyle, 3-5 parties de peroxyde de dibenzoyle et 1-2 parties d'hydroquinone ;
et dans lequel la surface supérieure et/ou la surface inférieure de la couche substrat est/sont revêtue(s) du prépolymère de résine photosensible ; alors que le prépolymère de résine photosensible est durci par rayonnement optique pour former une couche de résine photosensible d'impression, la surface de la couche de résine photosensible d'impression est imprimée par contact mécanique pour former une pluralité de fossés d'évacuation ou de rainures d'évacuation ; et la pluralité de fossés d'évacuation ou de rainures d'évacuation divisent la couche de résine photosensible d'impression en une pluralité de bosses.

2. Matériau de film antiadhésif de résine photosensible d'impression ayant une fonction d'évacuation selon la revendication 1, **caractérisé en ce que** la surface de la couche de résine photosensible est imprimée par impression d'un rouleau mécanique ou par transfert d'un film de transfert pour former les fossés d'évacuation ou les rainures d'évacuation.

3. Matériau de film antiadhésif de résine photosensible d'impression ayant une fonction d'évacuation selon la revendication 1, **caractérisé en ce qu'**un système de copolymérisation de l'oligomère d'acrylate liquide et de la résine époxy qui est un polymère avec plus de deux groupes époxy et est un produit de polycondensation d'époxy chloropropane et de bisphénol A comprend en outre 40-50% de diluant réactif, 0,1-0,75% de catalyseur, 3-6% d'accélérateur d'adhérence et 1-5% d'inhibiteur de polymérisation sur la base du rapport massique respectif du système réactif.

4. Matériau de film antiadhésif de résine photosensible d'impression ayant une fonction d'évacuation selon la revendication 1, **caractérisé en ce que** la dureté au crayon de la couche de résine photosensible d'impression est supérieure ou égale à 2H, dans lequel une méthode de mesure de dureté au crayon renvoie à la méthode de test au crayon GB/T6739-2006.

5. Matériau de film antiadhésif de résine photosensible d'impression ayant une fonction d'évacuation selon la revendication 1, **caractérisé en ce que** la distance entre chaque paire de fossés d'évacuation ou de rainures d'évacuation adjacents est de 200-600 µm, la largeur des fossés d'évacuation ou des rainures d'évacuation est de 6-60 µm, et la profondeur des fossés d'évacuation ou des rainures d'évacuation est de 3-30 µm.

6. Matériau de film antiadhésif de résine photosensible d'impression ayant une fonction d'évacuation selon la revendication 1, comprenant en outre une couche antiadhésive formée par revêtement de la couche de résine photosensible d'impression avec un agent antiadhésif de polysiloxane, **caractérisé en ce que** la quantité de revêtement sec de l'agent antiadhésif de polysiloxane est de 0,5-2,5 g/m².

7. Matériau de film antiadhésif de résine photosensible d'impression ayant une fonction d'évacuation selon l'une quelconque des revendications 1 à 6, **caractérisé en ce que** la couche substrat est l'un parmi un film de polyéthylène glycol téréphtalate, un film de polyimide, un film de polypropylène et un film de poly(chlorure de vinyle), ou l'un parmi les homopolymères, copolymères ou dérivés de polyéthylène glycol téréphtalate, de polyéthylène glycol téréphtalate, de polypropylène et de poly(chlorure de vinyle).

8. Procédé de préparation du matériau de film antiadhésif de résine photosensible d'impression ayant une fonction d'évacuation selon l'une quelconque des revendications 1 à 6, comprenant :
la préparation de l'oligomère d'acrylate liquide : le mélange de 70-80 parties d'acrylate de butyle, de 20-30 parties de méthacrylate de glycidyle, de 3-5 parties de peroxyde de dibenzoyle et de 1-2 parties d'hydroquinone, et le chauffage et la polymérisation du mélange dans un bain d'eau pour obtenir l'oligomère d'acrylate liquide ;
la préparation du prépolymère de résine photosensible : l'introduction de la résine époxy qui est un polymère avec plus de deux groupes époxy et est un produit de polycondensation d'époxy chloropropane et de bisphénol A dans l'oligomère d'acrylate liquide et la réalisation d'une copolymérisation pour obtenir le prépolymère de résine photosensible ;
la réalisation d'un revêtement avec le prépolymère de résine photosensible : le revêtement de la surface supérieure ou de la surface inférieure de la couche substrat avec le prépolymère de résine photosensible ; et
le durcissement et l'impression des fossés d'évacuation ou des rainures d'évacuation : tout en appliquant un rayonnement optique sur le prépolymère de résine photosensible revêtu pour former la couche de résine photosensible d'impression, la formation des fossés d'évacuation ou des rainures d'évacuation sur la surface de la couche de résine photosensible d'impression par un rouleau de gravure avec une structure bossée.

9. Procédé de préparation selon la revendication 8, comprenant en outre :
la réalisation d'un revêtement avec l'agent antiadhésif : le revêtement de la surface de la couche de résine photosensible d'impression avec la couche antiadhésive formée par un agent antiadhésif de siloxane, la quantité de revêtement sec de l'agent antiadhésif de siloxane étant de 0,5-2,5 g/m².

10. Utilisation du matériau de film antiadhésif de résine photosensible d'impression ayant une fonction d'évacuation selon l'une quelconque des revendications 1 à 6 dans un matériau adhésif sensible à la pression, **caractérisée en ce que** le matériau adhésif sensible à la pression est lié au matériau de film antiadhésif, et les fossés d'évacuation ou les rainures d'évacuation sont formés dans la surface du matériau adhésif sensible à la pression par copie du film antiadhésif.

11. Utilisation du matériau de film antiadhésif de résine photosensible d'impression ayant une fonction d'évacuation selon l'une quelconque des revendications 1 à 6 dans une housse de voiture et un film d'emballage.

12. Housse de voiture, comprenant un matériau de surface, une couche adhésive ancrée sur une surface inférieure du matériau de surface, et un film antiadhésif lié à la couche adhésive, **caractérisée en ce que** le film antiadhésif est le matériau de film antiadhésif de résine photosensible d'impression ayant une fonction d'évacuation selon l'une quelconque des revendications 1 à 6 ; et après la liaison du matériau de surface et de la couche adhésive ancrée sur la surface inférieure du matériau de surface au matériau de film antiadhésif de résine photosensible d'impression, la couche adhésive sur la surface inférieure du matériau de surface est imprimée par les bosses sur la surface de la couche de résine photosensible d'impression, et les fossés d'évacuation ou les rainures d'évacuation mises en correspondance avec celles-ci sont formées dans la couche adhésive.
